# EUROPÄISCHE PATENTANMELDUNG

(11) **EP 2 302 673 A2**
(43) Veröffentlichungstag der Anmeldung: **30.03.2011**
(21) Anmeldenummer: 10170772.7
(22) Anmeldetag: 26.07.2010
(51) Int. Cl.: H01L 23/34, H01L 23/544

(54) **Halbleiteranordnung und Verfahren zur Ermittlung der Sperrschichttemperatur eines Halbleiterbauelements**

(30) Priorität: 28.09.2009 DE 102009045068
(71) Anmelder: SEMIKRON Elektronik GmbH & Co. KG, 90431 Nürnberg (DE)
(72) Erfinder: Schuler, Stefan, 91052 Erlangen (DE)

(57) **Zusammenfassung**

Eine Halbleiteranordnung (2) enthält ein auf einem Träger (4) gehaltenes, eine Anschlussfläche (8) aufweisendes Halbleiterbauelement (6), eine auf dem Träger (4) angeordnete Kontaktfläche (12a), und einen die Anschlussfläche (8) mit der Kontaktfläche (12a) verbindenden Bonddraht (10), einen an der Anschlussfläche (8) angeschlossenen, von dieser weg führenden Leiter (14), der zusammen mit dem Bonddraht (10) und der Anschlussfläche (12a) einen Teil eines Thermoelements (16) bildet, dessen eines temperaturaktives Ende (22a) an der Anschlussfläche (8) gebildet ist.

## Beschreibung

Die Erfindung betrifft eine Halbleiteranordnung und ein Verfahren zur Ermittlung der Sperrschichttemperatur eines Halbleiterbauelements.

Eine hier in Rede stehende Halbleiteranordnung, z.B. ein IGBT-Modul umfasst ein Halbleiterbauelement, z.B. den eigentlichen IGBT-Chip, welcher auf einem Träger, z.B. einer DCB-Platte (Direct Copper Bonded) oder einem Chip-Substrat gehalten ist. Das Halbleiterbauelement weist hierbei eine Anschlussfläche, z.B. den Gate-Kontakt des IGBT (Isolated Gate Bipolar Transistor) auf. Auf dem Träger ist eine Kontaktfläche angeordnet. Die Kontaktfläche ist mit der Anschlussfläche über einen Bonddraht verbunden.

Halbleiteranordnungen bzw. Halbleiterbauelemente erzeugen während ihres Betriebs Abwärme. Insbesondere wenn das Halbleiterbauelement ein Leistungshalbleiterschalter ist, z.B. der o.g. IGBT, so ist dieses beim Schaltvorgang hoher Temperaturbeanspruchung ausgesetzt. Die Temperatur am Halbleiterbauelement, also dem eigentlichen Chip, kann hierbei z.B. innerhalb einer Sekunde um 120°C ansteigen. Ein derart thermisch hochbelastetes Bauteil ist in der Regel nach ca. 20.000 - 30.000 Lastwechseln mit einem Temperaturunterschied ΔT von 125°C zerstört. Bei dieser Zahlenangabe handelt es sich um einen Spezifikationswert, der im Rahmen einer Qualifizierung bestimmt wird, nicht um einen Praxiswert. Es ist daher gewünscht, die thermische Belastung, d.h. den Temperaturverlauf eines Halbleiterbauelements im Betrieb zu erfassen, um eine Aussage über die thermische Belastung des Bauelements zu erhalten.

Bekannt ist es z.B., die Sperrschichttemperatur in einem Halbleiterbauelement mittels mathematisch-physikalischer Modelle abzuschätzen, also zu berechnen oder zu simulieren. Die Sperrschichttemperatur wird hierbei anhand verschiedener anderer Messgrößen und physikalischer Parameter berechnet. Die physikalischen Parameter unterliegen hierbei jedoch fertigungstechnischen Schwankungen sowie einer Langzeitdrift: Beispielsweise verschlechtert sich der Wärmeübergangswiderstand zwischen Halbleiterbauelement und Träger, also z.B. Chip und DCB mit zunehmender Alterungsbelastung. In der Anfangsphase nach der Fertigstellung der Halbleiteranordnung wird in der Regel ein gewisses "Setzen" der Wärmeleitpaste, z.B. zur Ankopplung eines Kühlkörpers an das Halbleiterbauelement, beobachtet. Die entsprechende thermische Kopplung kann daher ebenfalls nur ungenügend modelliert werden. All dies führt zu einer Ungenauigkeit der Berechnungs- bzw. Simulationsergebnisse.

Aufgrund der genannten Schwierigkeiten bei der Simulation bzw. Berechnung der Temperatur in der Halbleiteranordnung bzw. dem Halbleiterbauelement ist es auch bekannt, die Temperatur direkt in der Halbleiteranordnung zu erfassen. Hierzu wird ein Temperatursensor, z.B. in Form eines Temperaturwiderstandes (NTC, negativ temperature coefficient) auf dem Träger angeordnet. Nachteil hierbei ist, dass zwar die Temperatur des Trägers erfasst wird, jedoch auch hier weit über -20° Temperaturunterschied zum eigentlichen Halbleiterbauelement auftreten können. Es verbleibt also eine unbekannte Temperaturdifferenz, z.B. zur Chipmitte hin. Die erfasste Temperatur gibt daher nur sehr ungenaue Auskunft über die tatsächliche Temperatur am bzw. im thermisch empfindlichen bzw. belasteten Halbleiterbauelement.

Das Temperaturgefälle zwischen der Chipmitte, also dem Halbleiterbauelement, und dem Träger, an welchem üblicherweise ein Temperatursensor angeordnet ist, ist in der Regel vergleichsweise hoch und wegen der Totzeit, d.h. der Ausbreitungszeit einer Temperaturänderung vom Halbleiterbauelement zum Träger bei deren Änderung auch nicht konstant. Der auf dem Träger angeordnete Temperatursensor, z.B. ein NTC ist daher alleine zur Temperaturbestimmung am Halbleiterbauelement ungeeignet.

Aufgabe der vorliegenden Erfindung ist es, eine verbesserte Halbleiteranordnung und ein verbessertes Verfahren zur Ermittlung der Sperrschichttemperatur eines Halbleiterbauelements anzugeben.

Die Erfindung beruht auf der Erkenntnis, ein Thermoelement zur Temperaturmessung zu verwenden. Bei einem Thermoelement werden zwei Leiter verschiedener Materialien durch Serienschaltung zu einem Stromkreis verbunden. Die beiden Verbindungsstellen sind die temperaturaktiven Enden des Thermoelements. Werden diese auf unterschiedliche Temperaturen gebracht und wird einer der beiden Leiter aufgetrennt und auf ein Spannungsmessgerät geschaltet, kann dort eine Thermospannung gemessen werden. Diese ist von der Temperaturdifferenz der beiden Verbindungsstellen abhängig.

Die Aufgabe wird hinsichtlich der Halbleiteranordnung gelöst durch eine Halbleiteranordnung gemäß Patentanspruch 1 der eingangsgenannten Ausgestaltung. Erfindungsgemäß weist die Halbleiteranordnung einen weiteren Leiter auf, welcher an der Anschlussfläche angeschlossen ist und von dieser wegführt. Der Leiter bildet zusammen mit dem Bonddraht und der Anschlussfläche einen Teil eines Thermoelements. Das eine temperaturaktive Ende des Thermoelements ist hierbei an der Anschlussfläche gebildet.

Im vorliegenden Fall werden also Leiter und Bonddraht an der Anschlussfläche verbunden. In der Regel weisen hierbei Anschlussfläche und Bonddraht gleiches Material auf, die Materialpaarung kann aber auch anders sein. Die Verbindungsstelle zwischen Anschlussfläche und Leiter bildet somit das erste temperaturaktive Ende des Thermoelements. Außerhalb des Halbleiterbauelements liegt dann das zweite temperaturaktive Ende, nämlich dort, wo Leiter und Bonddraht - oder ggf. deren Verlängerungen, z.B. Kupferleiterbahnen - zusammenkommen. Das zweite Ende wird dann z.B. auf einer bekannten Referenztemperatur gehalten, um über die aus dem Thermoelement bzw. der Thermospannung ermittelte Temperaturdifferenz die absolute Temperatur an der Anschlussfläche ermitteln zu können. Mit anderen Worten wird also ein zweites Material auf der Anschlussfläche kontaktiert, um so eine Thermospannung zu erzeugen.

In der erfindungsgemäßen Halbleiteranordnung ist also eine gegenüber dem Stand der Technik verbesserte Erfassung einer möglichst genauen Temperatur an der Anschlussfläche realisiert. Da die Anschlussfläche sich direkt am Halbleiterbauelement befindet, liefert diese eine möglichst genaue Temperatur des Halbleiterbauelements selbst, z.B. dessen Sperrschicht. Aus der Kenntnis dieser Temperatur kann die Stresssituation des Halbleiterbauelements besonders genau abgeschätzt werden. Aufgrund der genauen Kenntnis der Halbleitertemperatur und z.B. der Speicherung deren Verlaufs, kann die Lebensdauer des Halbleiterbauelements besonders genau abgeschätzt werden, bzw. sogar eine Prognose für eine verbleibende Restlebensdauer gestellt werden. Um ein hinreichend zuverlässige Aussage zur Restlebensdauer treffen zu können, muss eine möglichst genaue aktuelle Sperrschichttemperatur bekannt sein. Dank der Erfindung ist es möglich, die im Betrieb auftretenden Sperrschichttemperaturen aufzuzeichnen und z.B. einer speziellen Software zur weiteren Auswertung zuzuführen.

Die Erfindung nutzt den Vorteil, bereits vorhandene Strukturen am Halbleiterbauelement, nämlich den Bonddraht, zur Temperaturmessung zu nutzen. Dieser wird lediglich durch ein einfaches Element, nämlich einen einzigen zusätzlichen Leiter, zu einer Art Temperatursensor erweitert. Dies hat den Vorteil, dass auf dem Halbleiterbauelement kein vollständiger eigenständiger Temperatursensor unterzubringen ist.

Die Erfindung beachtet hiermit die notwendigen Randbedingungen, nämlich dass die genaue Erfassung der Sperrschichttemperatur problematisch ist, da das Halbleiterbauelement nicht in seiner Funktion beeinflusst werden darf. Auch sollte der Einfluss des Temperatursensors selbst auf die Chiptemperatur nur minimal und seine Reaktionszeit kurz sein. Weiterhin muss der Sensor für entsprechend hohe Betriebstemperaturen tauglich sein. All dies ist durch die Erfindung erfüllt.

Durch die exakte Verfolgung des Temperaturprofils des Halbleiterbauelements kann eine sehr genaue Vorhersage für die Lebensdauer des Bauelements realisiert werden. So ist es z.B. möglich, nach Art einer aus dem Automobilsektor bekannten Serviceanzeige den Benutzer der Halbleiteranordnung eine jeweilige voraussichtliche Restlaufzeit der Halbleiteranordnung anzugeben, in welcher mit hoher Wahrscheinlichkeit noch kein Bauteilausfall zu erwarten ist. Der Benutzer der Halbleiteranordnung kann so eine anstehende Wartung bzw. einen Bauteilaustausch der Halbleiteranordnung entsprechend dem bisherigen und vorgesehenen Betrieb planen.

Da die Thermospannungen von zu verwendenden Materialien für den Leiter äußerst gering sind, d.h. im niedrigen mV-Bereich liegen, sollte die Spannung des Thermoelements z.B. nicht während eines Kommutierungsvorgangs eines Halbleiterschalters als Halbleiterbauelement ausgelesen werden. Da für die Ansteuerung des Halbleiterbauelements in der Regel dessen Schaltsignal, z. B. die verwendete Pulsweitenmodulation (PWM) bekannt ist, ist dies einfach möglich. Bei einem getakteten Halbleiterbauelement bietet sich zur Störunterdrückung außerdem an, das Thermoelement gemittelt über mehrere Schaltperioden auszulesen.

Das zweite temperaturaktive Ende des Thermoelements kann an beliebiger Stelle liegen, an welcher z.B. dessen Temperatur als Referenztemperatur einfach erfassbar ist.

In einer bevorzugten Ausführungsform liegt jedoch das zweite temperaturaktive Ende des Thermoelements auf dem Träger. Das Thermoelement muss so nicht aus der Halbleiteranordnung herausgeführt werden, sondern bildet mit der Halbleiteranordnung eine integrierte Einheit. In einer bevorzugten Ausführungsform wird das zweite Temperaturaktive Ende nicht auf einer Referenztemperatur gehalten, sondern diese ermittelt. Die Bestimmung der Temperatur am Träger ist wesentlich einfacher als die des Halbleiterbauelements selbst. Hier können beispielsweise bekannte Verfahren bzw. Bauelement angewendet werden. Mit dieser Vorgehensweise kann der Temperaturwiderstand vom Halbleiterbauelement bzw. -chip zum Träger ermittelt werden.

In einer weiteren bevorzugten Ausführungsform weist die Halbleiteranordnung einen an das zweite temperaturaktive Ende des Thermoelements thermisch gekoppelten Thermosensor auf. Ein solcher Thermosensor kann z.B. ein herkömmlicher NTC-Widerstand sein. Dieser kann beispielsweise direkt an das zweite Ende des Thermoelements angebunden sein, z.B. an der Kontaktfläche oder am dem Halbleiterbauelement abgewandten Ende des Leiters angelötet sein, um so direkt dessen ersten elektrischen Anschluss zu bewerkstelligen und gleichzeitig eine thermische Kopplung herzustellen.

In einer weiteren bevorzugten Ausführungsform kann der Bonddraht ein erster Bonddraht und der Leiter ein zweiter Bonddraht sein. Die Kontaktfläche ist dann eine erste Kontaktfläche und der Leiter auf eine zweite Kontaktfläche gebondet. Auch die zweite Kontaktfläche ist hierbei auf dem Träger angeordnet.

In dieser Ausführungsform wird also mit anderen Worten das zusätzliche Bonden eines weiteren, für die Bildung eines Thermoelements geeigneten Drahtes an der Anschlussfläche vorgeschlagen. So wird der Temperatursensor an der Anschlussfläche in möglichst einfacher Weise gebildet. Ist die Anschlussfläche z.B. eine Aluminiummetalisierung, kann ein zweiter Bonddraht aus einem anderen Material als Aluminium gebondet werden. Beide Bonddrähte werden dann an den ersten und zweiten Kontaktflächen z.B. auf getrennte Kupferleiterbahnen in einem ausreichenden Abstand vom Chip, also dem Halbleiterbauelement, geführt. Dort, wo die Temperatur in der Regel geringer ist als am Halbleiterbauelement selbst, befindet sich dann auch der auf dem DCB- bzw. Träger üblicherweise integrierte NTC-Widerstand, mit dessen Wert die Temperaturspannung der temperaturaktiven Enden des Thermoelements in einem späteren Schritt heraus gerechnet werden kann.

Zu beachten ist hierbei, dass der zweite Bonddraht eine gute Bondbarkeit und eine zum Material der Anschlussfläche, z.B. Aluminium möglichst hohe Thermospannung aufweist. Auch sollte dieser aus einem Material bzw. einer Legierung bestehen, das nicht durch die Anschlussfläche, z.B. die Aluminiummetallisierung, diffundiert und die Eigenschaften des Halbleiterbauelements modifiziert.

Das zweite temperaturaktive Ende des Thermoelements kann besonders einfach an der ersten oder zweiten Kontaktfläche gebildet werden, da hier ohnehin die Bonddrähte zu befestigen sind. So kann hier ebenfalls in einfacher Weise ein Übergang auf ein thermoelektrisch unterschiedliches Material erfolgen. Ein weiterer Vorteil ist, dass insbesondere in der Nähe der Kontaktflächen beispielsweise ein entsprechender Temperatursensor plazierbar ist, um die Referenztemperatur des zweiten temperaturaktiven Endes zu ermitteln.

In einer weiteren Ausführungsform weist die Halbleiteranordnung eine Einrichtung zur Erkennung einer Unterbrechung des über Bonddraht, Anschlussfläche und Leiter führenden Strompfades auf. Bonddraht und Leiter, welche von der Anschlussfläche weggeführt sind, können somit gleichzeitig als Indikator für ein Lösen von Bonddraht und/oder Leiter, also einen "Abheber" an der Anschlussflächenkontaktierung herangezogen werden. Dies erfolgt durch eine einfache Schleifenmessung.

In einer weiteren vorteilhaften Ausführungsform ist das Halbleiterbauelement ein Schaltelement, z.B. ein IGBT und die Anschlussfläche ein Schalteingang des Schaltelements, z.B. dessen Gateanschluss. Insbesondere bei stark thermisch beanspruchten Leistungshalbleiterschaltern ist der Schaltanschluss häufig im Bereich der thermisch am stärksten belasteten Zone gelegen. Dort ist also eine Temperaturmessung am sinnvollsten. Außerdem ist das Potential bzw. dessen Schwankung bei solchen Halbleiterbauelementen dort noch am geringsten, so dass die elektrische Auswertung der Thermospannung einfach ist.

Hinsichtlich des Verfahrens wird die Aufgabe also gelöst durch ein Verfahren zur Ermittlung der Sperrschichttemperatur eines Halbleiterbauelements einer Halbleiteranordnung. Das Halbleiterbauelement ist auf einem Träger gehalten und weist eine Anschlussfläche auf. Auf dem Träger ist eine Kontaktfläche mit einem die Anschlussfläche mit der Kontaktfläche verbindenden Bonddraht angeordnet. Bei dem verfahren wird an der Anschlussfläche ein von dieser weg führender Leiter angeschlossen, der zusammen mit dem Bonddraht und der Anschlussfläche einen Teil eines Thermoelements bildet, dessen eines temperaturaktives Ende an der Anschlussfläche gebildet ist. Die Sperrschichttemperatur wird anhand der Temperatur des temperaturaktiven Endes ermittelt.

Das Verfahren zusammen mit seinen Vorteilen wurde bereits im Zusammenhang mit der erfindungsgemäßen Halbleiteranordnung erläutert.

In einer bevorzugten Verfahrensvariante wird der zeitliche Verlauf der Temperatur des temperaturaktiven Endes gespeichert und anhand des Verlaufs die Lebensdauer und/oder verbleibende Restlebensdauer des Halbleiterbauelements abgeschätzt.

In einer weiteren Verfahrensvariante wird die Temperatur des temperaturaktiven Endes zu einem Zeitpunkt erfasst, der nicht im Zeitbereich eines Kommutierungvorgangs im Halbleiterbauelement liegt.

In einer anderen Ausgestaltung wird der Zeitpunkt anhand des dem Halbleiterbauelement zur Ansteuerung zugeführten Schaltsignals ermittelt.

In einer bevorzugten Verfahrensvariante wird das Halbleiterbauelement mit einem mehrere Schaltperioden aufweisenden Schalttakt angesteuert. Die Temperatur des temperaturaktiven Endes wird dann in mehreren Schaltperioden erfasst und die Sperrschichttemperatur durch Mittelung der erfassten Temperaturen ermittelt.

Für eine weitere Beschreibung der Erfindung wird auf die Ausführungsbeispiele der Zeichnungen verwiesen. Es zeigen, jeweils in einer schematischen Prinzipskizze:
- Fig. 1: eine Halbleiteranordnung mit Thermoelement gemäß der Erfindung,
- Fig. 2: eine Tabelle von Materialien mit zugehörigen Thermo- spannungen,
- Fig. 3: einen zeitlichen Verlauf einer Steuerspannung der Halb- leiteranordnung,
- Fig. 4: einen gemessenen zeitlichen Temperaturverlauf an der Halbleiteranordnung,
- Fig. 5: eine Matrix gemäß Rainflow-Verfahren für den zeitlichen Temperaturverlauf an der Halbleiteranordnung.

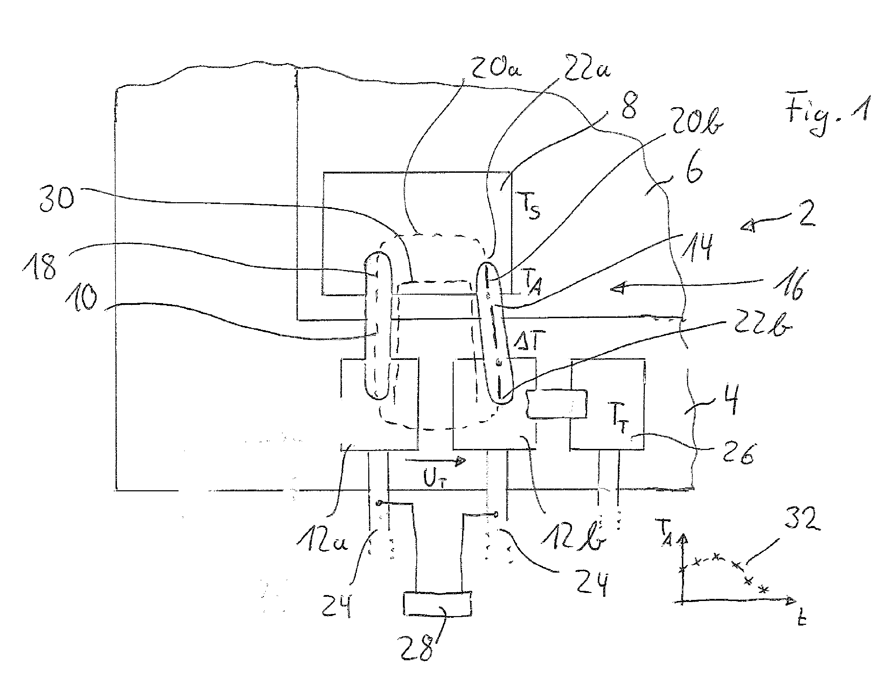

Fig. 1 zeigt einen Ausschnitt einer Halbleiteranordnung 2, im Beispiel eines IGBT-Moduls. Dieses umfasst einen Träger 4, im Beispiel eine DCB-Platine, auf welcher das eigentliche Halbleiterbauelement 6 in Form des IGBT bzw. IGBT-Chips angebracht ist. Das Halbleiterbauelement 6 weißt eine Anschlussfläche 8 in Form einer Aluminiummetalisierung auf. Die Anschlussfläche stellt den Gateanschluss des IGBT dar. Diese ist über einen Bonddraht 10 auf eine auf dem Träger 4 angeordnete erste Kontaktfläche 12a geführt. Über diesen Pfad wird der IGBT geschaltet.

Gemäß der Erfindung ist an der Anschlussfläche 8 ein zusätzlicher Leiter 14 in Form eines zweiten Bonddrahtes angeschlossen, welcher zu einer Kontaktfläche 12b führt. Der Leiter 14 weist ein zur Anschlussfläche 8 bzw. dem Bonddraht 10 verschiedenes Material auf, welches eine andere Thermospannung besitzt. Gemäß der Erfindung ist damit ein Thermoelement 16 gebildet, welches einen Stromkreis 18 bildet.

Der Stromkreis 18 bzw. das Thermoelement 16 weisen damit einen ersten Abschnitt 20a auf, welcher von der Kontaktfläche 12b über die Kontaktfläche 12a, den Bonddraht 10 zur Anschlussfläche 8 führt. Der Abschnitt 20a weist ein erstes Material auf. Der Abschnitt 20b besteht aus dem Leiter 14 und weist das andere Material auf. An beiden Enden des Leiters 14 entstehen daher die beiden temperaturaktiven Enden 22a,b des Thermoelements 16, welche damit die Temperaturen der Anschlussfläche 8 bzw. des Halbleiterbauelements 6 und der Kontaktfläche 12b bzw. des Trägers 4 entsprechen. Zwischen den Kontaktflächen 12a,b ist der Stromkreis 18 aufgetrennt und über die Zuleitungen 24 von der Halbleiteranordnung 2 weggeführt, um die entstehende Thermospannung U_{T} weiterzuleiten bzw. andernorts verarbeiten zu können.

Da die Thermospannung U_{T} lediglich eine Differenztemperatur ΔT zwischen den Enden 22a,b liefert, wird die absolute Temperatur T_{T} des Trägers 4 durch ein Thermosensor 26, im Beispiel einen NTC-Widerstand, erfasst, welcher thermisch an das Ende 22b gekoppelt ist. Zur Stromversorgung des Thermosensors 26 wird der Gateanschluss des IGBT gleich mitbenutzt. Vorteilhafterweise, nämlich zur genauen Temperaturerfassung, ist hierbei der Thermosensor 26 nicht an den Bonddraht 10, sondern direkt an den Leiter 14 und damit das temperaturaktive Ende 22b gekoppelt.

Der Thermosensor 26 wird über den nicht näher bezeichneten Anschluss und die Kontaktfläche 12b bzw. deren Zuleitung 24 ausgewertet und liefert die absolute Temperatur T_{T} des Trägers 4. Die absolute Temperatur T_{A} der Anschlussfläche 8 bzw. des Halbleiterbauelements 6 ergibt sich dann durch Addition der aus der Thermospannung U_{T} abgeleiteten Temperaturdifferenz ΔT. Die Temperatur T_{A} der Anschlussfläche 8 entspricht im Beispiel der Sperrschichttemperatur T_{S} des Halbleiterbauelements 6. Ggf. ist die absolute Sperrschichttemperatur T_{S} noch, z.B. durch Addition eines Offsets, aus der Temperatur T_{A} zu ermitteln, was jedoch in der erfindungsgemäßen Anordnung hochgenau möglich ist.

In einer vorteilhaften Ausführungsform ist außerdem an die Zuleitungen 24 eine Einrichtung 28 angeschlossen, welche zur Erkennung einer Unterbrechung eines Strompfades 30 dient, der von der Kontaktfläche 12a über den Bonddraht 10, die Anschlussfläche 8 und den Leiter 14 zur Kontaktfläche 12b führt. Eine Unterbrechung des Stromfades 30 ist ein eindeutiger Hinweis auf einen sich lösenden Bonddraht 10 oder Leiter 14, was einen Ausfall der Ansteuerung des Bauelements bewirkt.

In einer alternativen Ausführungsform kann z.B. auch die Kontaktfläche 12b und/oder die Anschlussfläche 8 gleiches Material wie der Leiter 14 aufweisen und der Bonddraht 10 aus einem anderen Material bestehen. Die entsprechenden Enden 22a,b der Abschnitte 20a bzw. 20b verschieben sich dann entsprechend an die Enden des Bonddrahtes 10 . Auch andere Materialpaarungen mit dritten oder weiteren Materialien für die sich im Stromkreis 18 des Thermoelements 16 befindlichen Leitungsabschnitte bzw. -elemente sind denkbar. Die Enden 22a,b verschieben sich entsprechend und können daher auch außerhalb des in Fig. 1 dargestellten Bereiches liegen.

Der zeitliche Verlauf 32 der Temperaturen T_{A} über der Zeit t wird in einer Ausführungsform des Verfahrens gespeichert. Aus dem Verlauf 32 wird dann die Lebensdauer T_{L} des Bauelements - z.B. insgesamt 3000 Stunden ab Inbetriebnahme - bzw. dessen zu erwartende Restlebensdauer T_{R} - z.B. noch 1000 Stunden, da sich das Bauteil bereits seit 2000 Stunden im Einsatz befindet - bis zu einem anzunehmenden Ausfall ermittelt.

Hierzu dient z.B. das bekannte Rainflow-Verfahren. Dieses basiert auf folgendem Hintergrund: Eine größere Temperaturänderung sowie eine höhere mittlere Temperatur am Bauelement während dieser Änderung bedeuten erhöhten thermischen und damit auch erhöhten mechanischen Stress. Das Rainflow-Verfahren arbeitet wie folgt.

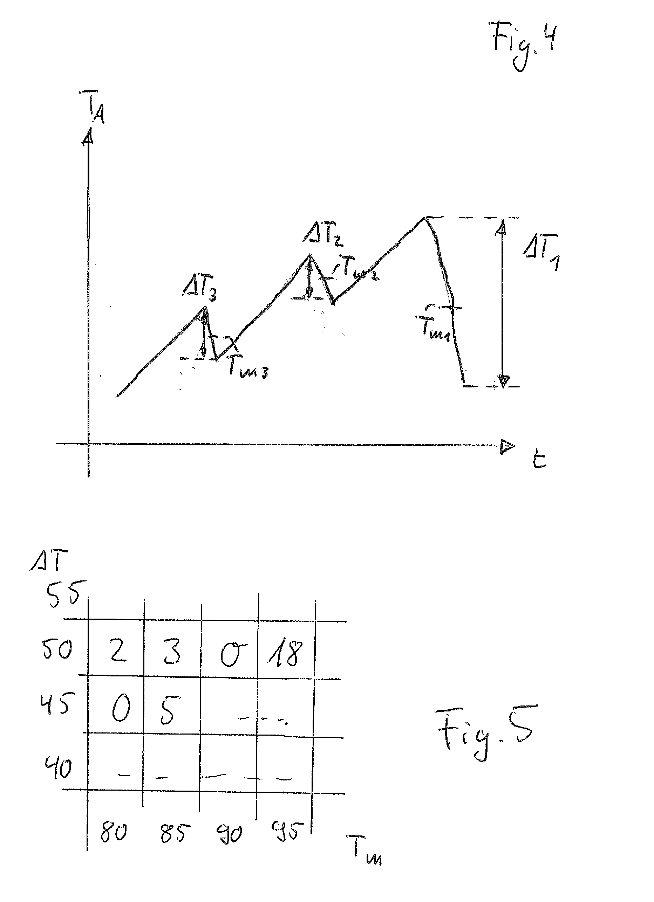

Fig. 4 zeigt den beispielhaften Verlauf 32 der gemessenen Temperatur T_{A} über der Zeit t in verbesserter Darstellung. Die Temperatur steigt bzw. fällt jeweils um verschiedene Temperaturdifferenzen ΔT₁₋₃. Für jede dieser Differenzen ΔT₁₋₃ existiert eine jeweilige mittlere Temperatur Tₘ₁₋₃.

Fig. 5 zeigt eine Matrix, in welche für jedes Paar einer gemessenen Temperaturdifferenz ΔT₁₋₃ sowie ihrer zugehörigen mittleren Temperatur Tₘ₁₋₃ ein Zählwert im entsprechenden Matrixelement um den Wert Eins erhöht wird. Beispielsweise ist für das Bauelement eine Temperaturdifferenz von 50°C bei einer mittleren Temperatur von 95°C bereits achtzehn mal gemessen worden. Mit anderen Worten gibt die Zahl im entsprechenden Matrixelement an, wie oft das jeweilige Paar von Temperaturdifferenz und mittlerer Temperatur aufgetreten ist.

Eine nicht dargestellte Koeffizienten- oder Gewichtungsmatrix
- mit gleicher Dimension wie obige Matrix - beinhaltet Faktoren, die den Temperaturstress bewerten. Eine elementweise Multiplikation beider Matrizen mit anschließender Summation führt zu einem Lebensdauerbewertungsfaktor. Hier ist auch eine
- unter Umständen gewichtete - Maximalwertbetrachtung denkbar. Dieser soll z.B. aussagen, dass nach der bisherigen Betriebsweise des Bauelements bereits 66% von dessen Lebensdauer erreicht sind.

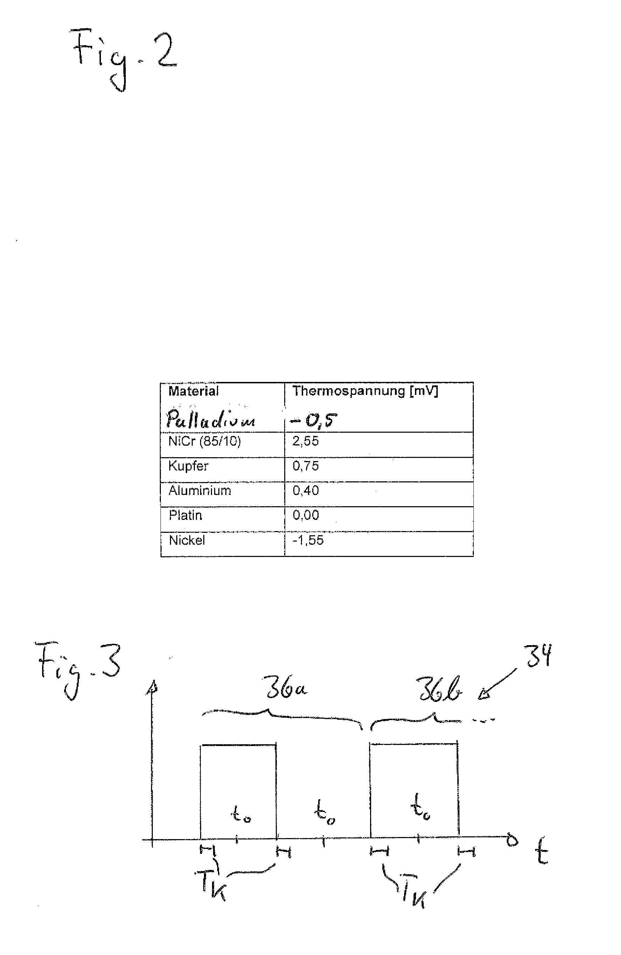

Fig. 2 zeigt eine Tabelle verschiedener Materialien und deren zugehörige Thermospannung bezogen auf Platin mit einer Temperatur T₀ = 0°C des ersten temperaturaktiven Endes eines entsprechenden Thermoelements und einer Temperatur T₁ = 100°C des anderen temperaturaktiven Endes.

Die in Fig. 2 gestellten Materialien wären alle entsprechend zur Ausführung des Bonddrahtes 10 bzw. Leiters 14 geeignet.

Fig. 3 zeigt ein der Anschlussfläche 8 zugeführtes Schaltsignal 34 in Form einer Steuerspannung des Halbleiterbauelements 6 über der Zeit t. In Zeitintervallen T_{K} findet jeweils ein Kommutierungsvorgang im Halbleiterbauelement 6 statt. In einer Ausführungsform des Verfahrens wird die Temperatur T_{A} jeweils zu Zeitpunkten t₀ erfasst, die nicht im Intervall T_{K} liegen.

Das gezeigte Schaltsignal 34 weist einen Schalttakt mit mehreren Schaltperioden 36a,b,... auf. Mit anderen Worten wird das Halbleiterbauelement 6 getaktet in Form einer PWM mit z.B. mehreren kHz Schaltfrequenz angesteuert. Die Temperatur T_{A} wird dann mehrmals, wie dargestellt, zu den Zeitpunkten t₀ ermittelt. Durch Mittelung von z.B. zehn Werten TA, also Zeitpunkten t₀ fünf aufeinanderfolgender Schaltperioden 36a,b,... wird dann ein einziger Wert der Sperrschichttemperatur T_{S} gemittelt.

## Patentansprüche

1. Halbleiteranordnung (2), mit einem auf einem Träger (4) gehaltenen, eine Anschlussfläche (8) aufweisenden Halbleiterbauelement (6), mit einer auf dem Träger (4) angeordneten Kontaktfläche (12a), und mit einem die Anschlussfläche (8) mit der Kontaktfläche (12a) verbindenden Bonddraht (10), mit einem an der Anschlussfläche (8) angeschlossenen, von dieser weg führenden Leiter (14), der zusammen mit dem Bonddraht (10) und der Anschlussfläche (12a) einen Teil eines Thermoelements (16) bildet, dessen eines temperaturaktives Ende (22a) an der Anschlussfläche (8) gebildet ist.

2. Halbleiteranordnung (2) nach Anspruch 1, bei dem das zweite temperaturaktive Ende (22b) des Thermoelements auf dem Träger (4) liegt.

3. Halbleiteranordnung (2) nach einem der vorhergehenden Ansprüche, mit einem an das zweite temperaturaktive Ende (22b) des Thermoelements (16) thermisch gekoppelten Thermosensor (26).

4. Halbleiteranordnung (2) nach einem der vorhergehenden Ansprüche, bei dem der Bonddraht (10) ein erster Bonddraht, die Kontaktfläche (12a) eine erste Kontaktfläche und der Leiter (14) ein zweiter Bonddraht ist, der auf eine zweite, auf dem Träger (4) angeordnete Kontaktfläche (12b) geführt ist.

5. Halbleiteranordnung (2) nach einem der vorhergehenden Ansprüche, mit einer Einrichtung (28) zur Erkennung einer Unterbrechung des über Bonddraht (10), Anschlussfläche (8) und Leiter (14) führenden Strompfades (30).

6. Halbleiteranordnung (2) nach einem der vorhergehenden Ansprüche, bei dem das Halbleiterbauelement (6) ein Schaltelement und die Anschlussfläche (8) ein Schalteingang dessen ist.

7. Verfahren zur Ermittlung der Sperrschichttemperatur (T_{S}) eines Halbleiterbauelements (6) einer Halbleiteranordnung (2), wobei dieses auf einem Träger (4) gehalten ist und eine Anschlussfläche (8) aufweist, und auf dem Träger (4) ein Kontaktfläche (12a) mit einem die Anschlussfläche (8) mit der Kontaktfläche (12a) verbindenden Bonddraht (10) angeordnet ist, bei dem:
- an der Anschlussfläche (8) ein von dieser weg führenden Leiter (14) angeschlossen wird, der zusammen mit dem Bonddraht (10) und der Anschlussfläche (12a) einen Teil eines Thermoelements (16) bildet, dessen eines temperaturaktives Ende (22a) an der Anschlussfläche (8) gebildet ist,
- die Sperrschichttemperatur (T_{S}) anhand der Temperatur (T_{A}) des temperaturaktiven Endes (22a) ermittelt wird.

8. Verfahren nach Anspruch 7, bei dem der zeitliche Verlauf (32) der Temperatur (T_{A}) des temperaturaktiven Endes (22a) gespeichert wird und anhand des Verlaufs (32) die Lebensdauer (T_{L}) und/oder verbleibende Restlebensdauer (T_{R}) des Halbleiterbauelements (6) abgeschätzt wird.

9. Verfahren nach Anspruch 7 oder 8, bei dem die Temperatur (T_{A}) des temperaturaktiven Endes (22a) zu einem Zeitpunkt (t₀) erfasst wird, der nicht im Zeitbereich (T_{K}) eines Kommutierungvorgangs im Halbleiterbauelement (6) liegt.

10. Verfahren nach Anspruch 9, bei dem der Zeitpunkt (t₀) anhand des dem Halbleiterbauelement (6) zur Ansteuerung zugeführten Schaltsignals (34) ermittelt wird.

11. Verfahren nach einem der Ansprüche 8 bis 10, wobei das Halbleiterbauelement (6) mit einem mehrere Schaltperioden (36a,b) aufweisenden Schalttakt angesteuert wird, bei dem die Temperatur (T_{A}) des temperaturaktiven Endes (22a) in mehreren Schaltperioden (36a,b) erfasst wird und die Sperrschichttemperatur (T_{S}) durch Mittelung der erfassten Temperaturen (T_{A}) ermittelt wird.
